# EUROPEAN PATENT SPECIFICATION

(11) **EP 4 315 803 B1**
(45) Date of publication and mention of the grant of the patent: **20.08.2025**
(21) Application number: 22722983.8
(22) Date of filing: 30.03.2022
(51) Int. Cl.: H04L 67/025, H04L 67/04, H04L 67/125, H04L 67/55

(54) **EVENT MONITORING AT A CLOUD SERVICE**
EREIGNISÜBERWACHUNG MITTELS EINES CLOUD-DIENSTES
SURVEILLANCE D'ÉVÉNEMENTS SUR UN SERVICE EN NUAGE

(30) Priority: 30.03.2021 US 202163168004 P
(43) Date of publication of application: 07.02.2024
(73) Proprietor: Johnson Controls Fire Protection LP, Boca Raton, FL 33487 (US)
(72) Inventor: VOIA, Fabiana, Boca Raton, FL 33487 (US); MESSIER, Alexandre, Boca Raton, FL 33487 (US); SINGH, Jagdeep, Boca Raton, FL 33487 (US); COURNOYER, Jérome, Boca Raton, FL 33487 (US)
(74) Representative: Meissner Bolte Nürnberg
(86) International application number: PCT/US2022/071451
(87) International publication number: WO 2022/213095

(56) References cited:
- WO-A1-2018/160181
- US-A1- 2019 272 736

## Description

### CLAIM OF PRIORITY

The present Application for Patent claims priority to U.S. Provisional Application No. 63/168,004 entitled "CLOUD-BASED FIRE PANEL APPLICATION" filed March 30, 2021.

### TECHNICAL FIELD

Aspects of the present disclosure relate generally to cloud-based event monitoring, and more particularly, to systems and methods for simulating control panel state and control panel responses.

### BACKGROUND

In some event monitoring systems, burdensome loads are being placed on the control panels configured to monitor an event status of a location based on one or more connected event sources. For example, some systems may require a control panel to respond to request for status information from multiple subscribers. However, due to the limited capabilities (e.g., processing and memory limitations) of control panels, many control panels are ill-equip to perform event monitoring of connected event sources, while fulfilling status request of subscribers to the control panel. Further, the inability to effectively collect event information from event sources and provide status information corresponding to events detected by the event sources to subscribers can prove fatal and/or costly in vital event monitoring contexts, e.g., fire safety systems. US 2019/272736 A1 describes a system and method for automatically providing alarm signalling to inform an owner and other authorized entities in a manner predetermined by the user when alarm situations and/or alarm worthy situations occur while an alarm system is being intentionally destroyed.

### SUMMARY

The following presents a simplified summary of one or more aspects in order to provide a basic understanding of such aspects. This summary is not an extensive overview of all contemplated aspects, and is intended to neither identify key or critical elements of all aspects nor delineate the scope of any or all aspects. Its sole purpose is to present some concepts of one or more aspects in a simplified form as a prelude to the more detailed description that is presented later.

An example aspect includes a method for event monitoring at a cloud service, comprising receiving, from a control panel coupled with a plurality of control sensors within a supervised premises, a plurality of event messages corresponding to events detected by the plurality of control sensors within the supervised premises. The method further includes generating a status simulation for the control panel based on the plurality of event messages, the status simulation representing a current status of the control panel. Additionally, the method further includes creating a subscription of a client service to the control panel based on a request from the client service. Additionally, the method further includes transmitting, to the client service based on the subscription, status information for the control panel derived from the status simulation.

Another example aspect includes an apparatus for event monitoring at a cloud service, comprising a memory and a processor communicatively coupled with the memory. The processor is configured to receive, from a control panel coupled with a plurality of control sensors within a supervised premises, a plurality of event messages corresponding to events detected by the plurality of control sensors within the supervised premises. The processor is further configured to generate a status simulation for the control panel based on the plurality of event messages, the status simulation representing a current status of the control panel. Additionally, the processor further configured to create a subscription of a client service to the control panel based on a request from the client service. Additionally, the processor further configured to transmit, to the client service based on the subscription, status information for the control panel derived from the status simulation.

Another example aspect includes an apparatus for event monitoring at a cloud service, comprising means for receiving, from a control panel coupled with a plurality of control sensors within a supervised premises, a plurality of event messages corresponding to events detected by the plurality of control sensors within the supervised premises. The apparatus further includes means for generating a status simulation for the control panel based on the plurality of event messages, the status simulation representing a current status of the control panel. Additionally, the apparatus further includes means for creating a subscription of a client service to the control panel based on a request from the client service. Additionally, the apparatus further includes means for transmitting, to the client service based on the subscription, status information for the control panel derived from the status simulation.

Another example aspect includes a computer-readable medium storing instructions for event monitoring at a cloud service, wherein the instructions are executable by a processor to receive, from a control panel coupled with a plurality of control sensors within a supervised premises, a plurality of event messages corresponding to events detected by the plurality of control sensors within the supervised premises. The instructions are further executable to generate a status simulation for the control panel based on the plurality of event messages, the status simulation representing a current status of the control panel. Additionally, the instructions are further executable to create a subscription of a client service to the control panel based on a request from the client service. Additionally, the instructions are further executable to transmit, to the client service based on the subscription, status information for the control panel derived from the status simulation.

To the accomplishment of the foregoing and related ends, the one or more aspects comprise the features hereinafter fully described and particularly pointed out in the claims. The following description and the annexed drawings set forth in detail certain illustrative features of the one or more aspects. These features are indicative, however, of but a few of the various ways in which the principles of various aspects may be employed.

### BRIEF DESCRIPTION OF THE DRAWINGS

FIG. 1 is a diagram of an example of a cloud computing system for event monitoring, according to some implementations.
FIG. 2A is a flow diagram of an example of a method of updating a control panel simulation, according to some implementations.
FIG. 2B is a flow diagram of an example of a method of updating a control panel simulation, according to some implementations.
FIG. 3 is block diagram of an example of a computer device configured to process excess event messages using a mobile application, according to some implementations.
FIG. 4 is a flow diagram of an example of a method of simulating a control panel state and a control panel response, according to some implementations.

### DETAILED DESCRIPTION

Various aspects are now described with reference to the drawings. In the following description, for purposes of explanation, numerous specific details are set forth in order to provide a thorough understanding of one or more aspects. It may be evident, however, that such aspect(s) may be practiced without these specific details.

This disclosure describes techniques for simulating control panel state and control panel responses. In particular, aspects of the present disclosure provide a cloud-based status simulator that may simulate the status of a control panel based on event messages received from the control panel, and satisfy requests for status information from subscribers to the control panel. Accordingly, for example, a cloud-based status simulator may generate a simulation of the control panel status and employ the status simulation to satisfy request for the status of the control instead of requiring the control panel to have an active role in disseminating status information, thereby gaining the scalability, reliability, and performance benefits of cloud computing while reducing the processing load placed on low resource devices having limited computing capabilities.

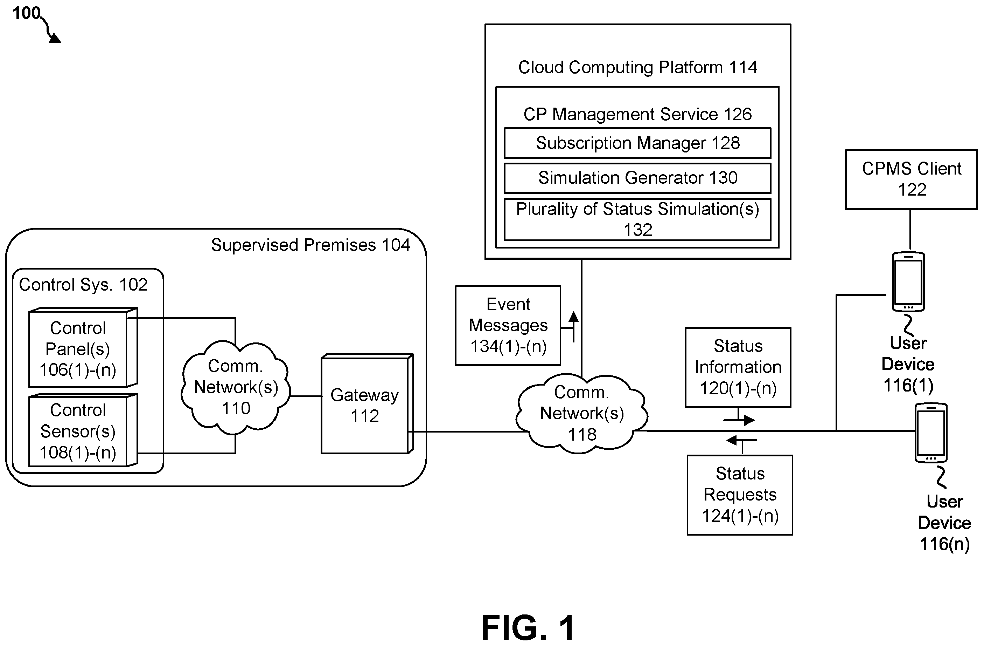

FIG. 1 is a diagram of an example of a control panel management system (CPMS) 100 for synchronizing an event monitoring application with an event monitoring service, according to some implementations. As illustrated in FIG. 1, a control panel management system (CPMS) 100 may include a control system 102 deployed within a supervised premises 104. Further, the control system 102 may include one or more control panels 106(1)-(n), one or more control sensors 108(1)-(n) deployed within the supervised premises 104, one or more communication networks 110(1)-(n), and a gateway 112. An example of a control sensor 108 may include a fire alarm and a corresponding example of a control panel 106 may include a fire panel configured to receive event information (e.g., smoke detected within a particular area of the supervised premises 104) from one or more fire alarms. Another example of a control sensor 108 may include a motion sensor and a corresponding example of a control panel is a security alarm panel configured to receive event information (e.g., motion detected within a particular area of the supervised premises) from one or more motion sensors. In some implementations, a communication network 110 may include a plain old telephone system (POTS), a radio network, a cellular network, an electrical power line communication system, one or more of a wired and/or wireless private network, personal area network, local area network, wide area network, and/or the Internet. Further, in some aspects, the control panels 106(1)-(n), the control sensors 108(1)-(n), and the gateway 112 may be configured to communicate via the communication networks 110(1)-(n).

In addition, the CPMS 100 may include a cloud computing platform 114, one or more user devices 116(1)-(n), and one or more communication networks 118(1)-(n). The communication network(s) 118 may comprise any one or combination of multiple different types of networks, such as cellular networks, wireless networks, local area networks (LANs), wide area networks (WANs), personal area networks (PANs), the Internet, or any other type of network configured to communicate information between computing devices (e.g., the cloud computing platform 114, the user devices 116(1)-(N), and the gateway 112). Some examples of the user device 116 include smartphones and computing devices, Internet of Things (IoT) devices, video game systems, robots, process automation equipment, sensors, control devices, vehicles, transportation equipment, virtual and augmented reality (VR and AR) devices, industrial machines, etc.

Further, the cloud computing platform 114 may be configured to provide panel status information 120(1)-(n) for the control panels 106(1)-(n) to the CPMS clients 122(1)-(n) of the user devices 116(1)-(n) via the communication network 118. For example, in some aspects, the cloud computing platform 114 may provide status information 120(1) for the control panel 106(1) to the first CPMS client 122(1) of the first user device 116(1) during a first period in time. As another example, in some aspects, the cloud computing platform 114 may provide status information 120(2) for the second control panel 106(2) to the first CPMS client 122(1) of the first user device 116(1). As yet still another example, in some aspects, the cloud computing platform 114 may provide status information 120(3) for the first control panel 106(2) to the first CPMS client 122(1) of the first user device 116(1) during a second period in time. In some aspects, CPMS client 122 may be a mobile application, desktop application, or a web application. Further, in some aspects, the CPMS client 122 may send a status request 124, and the cloud computing platform 114 may be configured to transmit the status information 120 in response to a status request 124. For example, the first CPMS client 122(1) may transmit a first status request 124 to the cloud computing platform and the cloud computing platform may respond with the first information status information 120(1). In some other aspects, the cloud computing platform 114 may provide the status information 120(2) to the CPMS client 122 may transmit the status information 120 of a control panel 106 in response to the CPMS client 122 subscribing to the control panel 106 via the cloud computing platform 114.

As illustrated in FIG. 1, the cloud computing platform 114 may include a control panel management service 126 configured to manage the control panels 106(1)-(n) and provide the status information 120 to the CPMS clients 122 subscribed to the control panels 106(1)-(n). Furthermore, as illustrated in FIG. 1, the control panel management service 126 may include a subscription manager 128, a simulation generator 130, and a plurality of status simulation 132(1)-(n). As described herein, the subscription manager 128 may manage the subscriptions of the CPMS clients 122 to the control panels 106. For example, in some aspects, the subscription manager 128 may create a subscription by a CPMS client 122 to the control panel 106(1) during an initialization process between a CPMS client 122(1) and the control panel management service 126. Once the CPMS client 122 is subscribed to the control panel 106(1), the control panel management service 126 may be configured to provide status updates via the status information 120(1)-(n) to the CPMS clients 122. As an example, if the status of the control panel 106(1) changes due to an event, the control panel management service 126 may be configured to send status information 120(1) identifying the status change based upon the CPMS client 122(1) subscribing to the control panel 106(1).

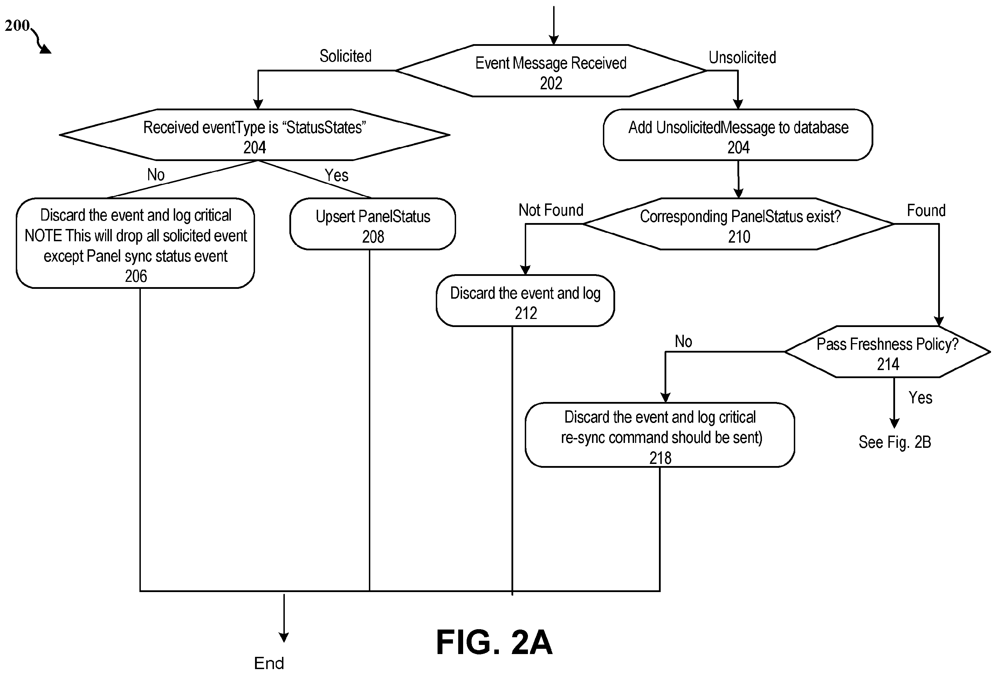

In some aspects, the simulation generator 130 may be configured to collect a plurality of event messages 134 generated and transmitted the control panels 106(1), and generate status simulation 132 for each of the control panels 106 based up on the corresponding event messages 134 of the control panel 106. As described in detail below with respect to FIGS. 2A-2B, the simulation generator 130 may identify one or more attributes of an event message 134 transmitted to the control panel management service 126 by a control panel 106, and determine whether to update the status simulation 132 of the control panel 106 based upon the one more identified attributes. In some aspects, the status simulation may be stored in one or more records of a database. Further, the control panel management service 126 may be configured to provide the status information 120(1)-(n) to the CPM's clients 122 based upon the status simulation 132. As a result, the complex and burdensome task of informing the CPMS clients 122 of the panel status of a control panel 106 is shifted to the cloud computing platform 114 which has far greater processing capabilities in comparison to the control panels 106(1)-(n).

FIGS. 2A-2B illustrate a flow diagram of an example of a method 200 of updating a status simulation of a control panel, according to some implementations. At step 202, the control panel management service 126 may receive an event message from a control panel 106, and the simulation generator 130 may determine whether the event message 134 is a solicited message or an unsolicited message. As used herein, in some aspects, a "solicited message" may refer to a message requested by the recipient and including full state information for the transmitting control panel, e.g., the status information of the control sensors associated with control panel. In some aspects, a solicited message may be transmitted by a control panel during a reboot/restart and/or during initialization of a CPMS client. As used herein, in some aspects, an "unsolicited message" may refer to a message that was not requested by the recipient and does not include full state information of the transmitting control panel. In some aspects, unsolicited messages may be employed to transmit incremental updates to the panel status of a control panel 106. Further, a solicited message transmitted by a control panel 106 may be larger than an unsolicited message transmitted by the control panel 106, as the unsolicited message will not contain as much status information. If the event message 134 is a solicited message, the simulation generator 130 may proceed to step 204, and if the event message 134 is an unsolicited message, the simulation generator 130 may proceed to step 206.

At step 204, the simulation generator 130 may determine whether the event message 134 identified as a solicited message includes one or more status states of the control sensors 108 of the control panel 106. As described herein, a status state may refer to the state of a control sensor configured to transmit event information to a particular control panel 106. For example, if a control panel 106 is a fire panel, then a corresponding control sensor 108 may be smoke detector with the following status states: fire, trouble, or supervisory. If the event message 134 includes status states of the control sensors 108, the simulation generator 130 may proceed to step 208, and perform an upsert using the panel status of the control panels 106 (e.g., the status states of the control sensors 108 couple to the control panel 106). In some aspects, the upsert may generate the status simulation 132 of the control panel 106. If the event message does not include status states of the control sensors, the simulation generator may discard the event message.

At step 204, at the simulation generator 130 may store the event message 134 to a storage component of the cloud computing platform 114, and proceed to step 210. At step 210 the simulation generator 130 may determine whether the event message 134 corresponds to an existing status simulation 132. If the event message 134 does not correspond to an existing status simulation 132, the simulation generator 130 may proceed to step 212. If the event message 134 does correspond to an existing status simulation 132, the simulation generator 130 may proceed to step 214.

At step 212, the simulation generator 130 may discard the event message 134 and log receipt of the event message 134. At step 214, the simulation generator 130 may determine whether the event message 134 meets a freshness policy implemented by the cloud computing platform 114. In some examples, the freshness policy may be based on a timestamp of the event message 134 generated at the time of creation of the event message 134 by the control panel 106 and/or a sequence number generated by the cloud computing platform 114 upon receipt of the event message 134. Further, the timestamp and/or the sequence number of the event message 134 may be compared to the time stamp and/or sequence number of the status simulation 132 of the control panel 106 that transmitted the event message. If the event message 134 was generated after the timestamp associated with the status simulation 132 and/or received after the sequence number associated with the status simulation 132, the simulation generator 130 may proceed to step 216. If the event message 134 does not meet the freshness policy (i.e., the event message 134 was generated before the timestamp associated with the status simulation 132 and/or received by the cloud computing platform 114 before generation of the sequence number associated with the status simulation 132, the simulation generator 130 may proceed to step 218 and discard the event message 134.

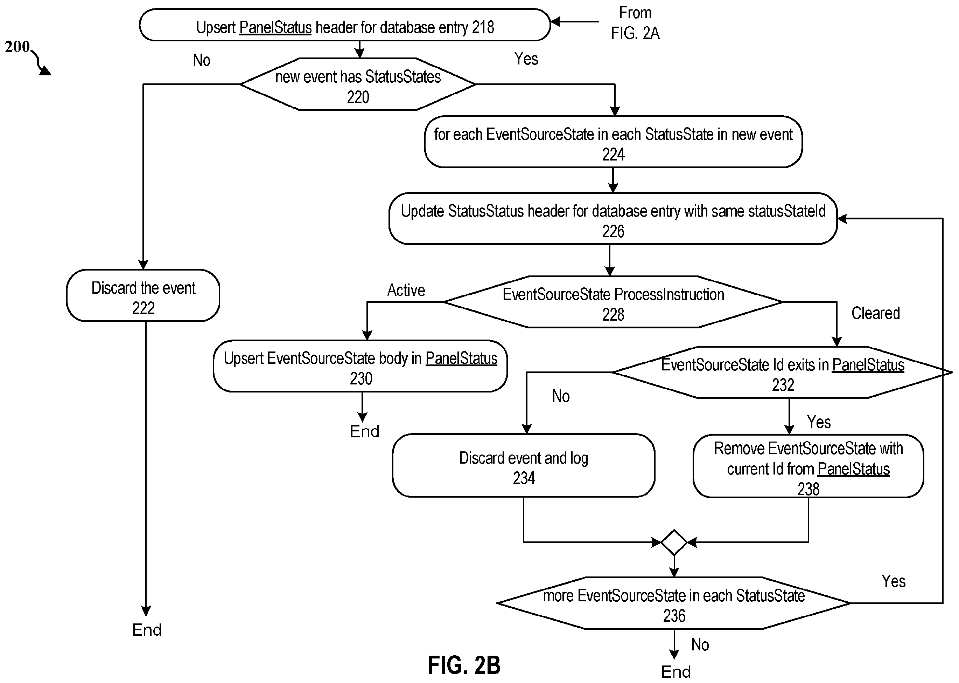

As illustrated in FIG. 2B, at step 218, the simulation generator 130 may upsert header information used to store the status simulation 132 of the control panel 106, and proceed to step 220. At step 220, the simulation generator 130 may determine whether the event message 134 includes status states of the control sensors 108 of the control panel 106 that transmitted the event message 134. If the event message 134 does not include status states, simulation generator 130 may proceed to step 222 and discard the event message 134. If the event message 134 does include status states, the simulation generator may proceed to step 224.

At step 224, the simulation generator 130 may identify each control sensor 108 having a status state within the event message 134, and proceed to step 226. At step 226, the simulation generator 130 may update the header information within the status simulation 132 for a control sensor identified at step 224, and proceed to step 228. At step 228, the simulation generator 130 may determine whether the event message 134 corresponds to an active event or the clearance of an active event. If the event message 134 corresponds to an active event, the simulation generator 130 may proceed to step 230 and update the contents of the status simulation 132 corresponding to the identified control sensor 108. If the event message 134 corresponds to the clearance of an earlier active event, the simulation generator 130 may proceed to step 232.

At step 232, the simulation generator 130 made determine whether the event that the event message 134 intends to clear is identified within the status simulation 132. In some aspects, the simulation generator 130 may determine that the event is identified within the status simulation 132 based upon detecting an event identifier identified within the event message 134 within the status simulation 132. Further, if the event is not identified within the status simulation 132, the simulation generator 130 may proceed to step 234. At step to 234, the simulation generator 130 may discard the event message 134, and proceed to step 236. If the event is identified within the status simulation 132, the simulation generator 130 may proceed to step 238. At step 238, the simulation generator 130 may clear the event formally identified as active within the status simulation 132, and proceed to step 236. At step 236, the simulation generator may repeat steps 224 to 238 for each of the identified control sensors or end processing of the event message when all of the identified control sensors have been analyzed.

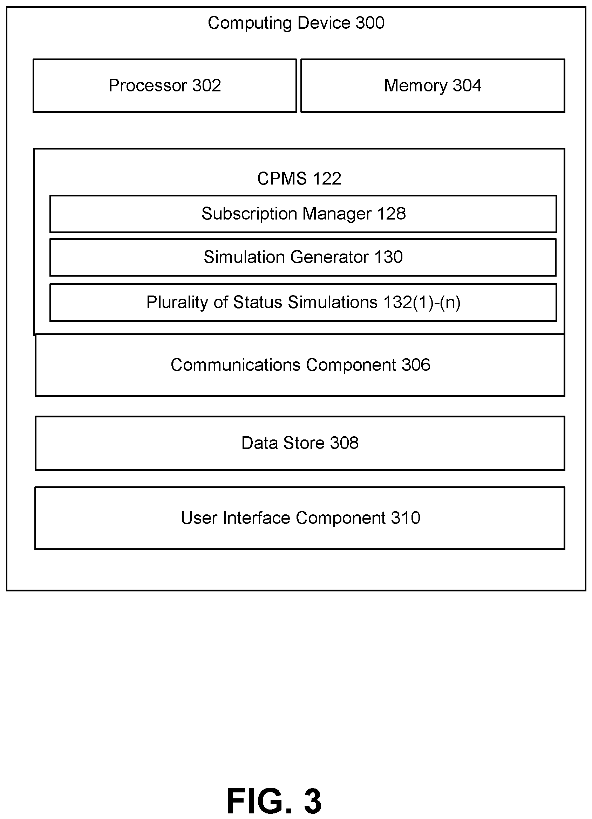

FIG. 3 is block diagram of an example of a computer device configured to simulate control panel state and control panel responses, according to some implementations. Referring to FIG. 3, a computing device 300 may implement all or a portion of the functionality described herein. The computing device 300 may be or may include or may be configured to implement the functionality of at least a portion of the CPMS 100, or any component therein. For example, the computing device 300 may be or may include or may be configured to implement the functionality of the user device 116, the control panel 106, the cloud computing platform 114, or the control sensors 108(1)-(N). The computing device 300 includes a processor 302 which may be configured to execute or implement software, hardware, and/or firmware modules that perform any functionality described herein. For example, the processor 302 may be configured to execute or implement software, hardware, and/or firmware modules that perform any functionality described herein with reference to the CPMS client 122, or any other component/system/device described herein.

The processor 302 may be a micro-controller, an application-specific integrated circuit (ASIC), a digital signal processor (DSP), or a field-programmable gate array (FPGA), and/or may include a single or multiple set of processors or multi-core processors. Moreover, the processor 302 may be implemented as an integrated processing system and/or a distributed processing system. The computing device 300 may further include a memory 304, such as for storing local versions of applications being executed by the processor 302, related instructions, parameters, etc. The memory 304 may include a type of memory usable by a computer, such as random-access memory (RAM), read only memory (ROM), tapes, magnetic discs, optical discs, volatile memory, nonvolatile memory, and any combination thereof. Additionally, the processor 302 and the memory 304 may include and execute an operating system executing on the processor 302, one or more applications, display drivers, etc., and/or other components of the computing device 300.

Further, the computing device 300 may include a communications component 306 that provides for establishing and maintaining communications with one or more other devices, parties, entities, etc. utilizing hardware, software, and services. The communications component 306 may carry communications between components on the computing device 300, as well as between the computing device 300 and external devices, such as devices located across a communications network and/or devices serially or locally connected to the computing device 300. In an aspect, for example, the communications component 306 may include one or more buses, and may further include transmit chain components and receive chain components associated with a wireless or wired transmitter and receiver, respectively, operable for interfacing with external devices.

Additionally, the computing device 300 may include a data store 308, which can be any suitable combination of hardware and/or software, that provides for mass storage of information, databases, and programs. For example, the data store 308 may be or may include a data repository for applications and/or related parameters not currently being executed by processor 302. In addition, the data store 308 may be a data repository for an operating system, application, display driver, etc., executing on the processor 302, and/or one or more other components of the computing device 300.

The computing device 300 may also include a user interface component 310 operable to receive inputs from a user of the computing device 300 and further operable to generate outputs for presentation to the user (e.g., via a display interface to a display device). The user interface component 310 may include one or more input devices, including but not limited to a keyboard, a number pad, a mouse, a touch-sensitive display, a navigation key, a function key, a microphone, a voice recognition component, or any other mechanism capable of receiving an input from a user, or any combination thereof. Further, the user interface component 310 may include one or more output devices, including but not limited to a display interface, a speaker, a haptic feedback mechanism, a printer, any other mechanism capable of presenting an output to a user, or any combination thereof.

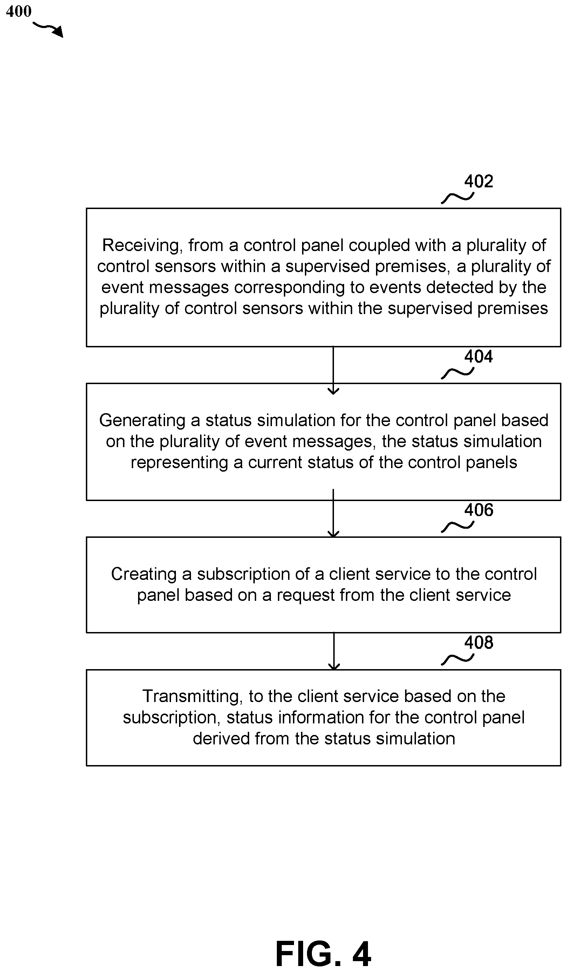

Referring to FIG. 3 and FIG. 4, in operation, computing device 300 may perform a method 400 of wireless communication, by such as via execution of CPMS client 122 by processor 302 and/or memory 304.

At block 402, the method 400 includes receiving, from a control panel coupled with a plurality of control sensors within a supervised premises, a plurality of event messages corresponding to events detected by the plurality of control sensors within the supervised premises. For example, in an aspect, computing device 300, processor 302, memory 304, cloud computing platform 114, control panel management service 126, and/or simulation generator 130 may be configured to or may comprise means for receiving, from a control panel coupled with a plurality of control sensors within a supervised premises, a plurality of event messages corresponding to events detected by the plurality of control sensors within the supervised premises. For example, the receiving at block 402 may include the cloud computing platform 114 receiving a plurality of event messages 134 from the control panel 106(1).

At block 404, the method 400 includes generating a status simulation for the control panel based on the plurality of event messages, the status simulation representing a current status of the control panel. For example, in an aspect, computing device 300, processor 302, memory 304, control panel management service 126, and/or simulation generator 130 may be configured to or may comprise means for generating a status simulation for the control panel based on the plurality of event messages, the status simulation representing a current status of the control panel. For example, the generating at block 404 may include the 130// generating a status simulation 132 of the control panel 106(1) based on the plurality of event messages. Further, for example, the generating at block 404 may be performed in order to create a local representation (e.g., a status simulation) of the status of a control panel 106. In addition, the control panel management service 126 may employ the local representation to provide status information 120 to the subscribers of a control panel 106 in order to reduce the load place on control panels 106, which are normally devices having limited processing capability and often unable to scale as the number of subscribers and/or control sensors 108 increases.

At block 406, the method 400 includes creating a subscription of a client service to the control panel based on a request from the client service. For example, in an aspect, computing device 300, processor 302, memory 304, control panel management service 126, and/or subscription manager 128 may be configured to or may comprise means for creating a subscription of a client service to the control panel based on a request from the client service. For example, the creating at block 406 may include the subscription manager 128 generate subscription of the CPMS client 122(1) to the control panel 106(1). Further, in some aspects, the subscription may be use by the control panel management service 126 to passively update the subscribers of a control panel 106 of the panel status of the control pane 106 without the subscribers having to actively poll the control panel management service 126 by sending status requests 124 to the control panel 106.

At block 408, the method 400 includes transmitting, to the client service based on the subscription, status information for the control panel derived from the status simulation. For example, in an aspect, computing device 300, processor 302, memory 304, and/or the control panel management service 126 may be configured to or may comprise means for transmitting, to the client service based on the subscription, status information for the control panel derived from the status simulation. For example, the transmitting at block 408 may include the control panel management service 126 to transmit status information 120 derived from the status simulation 132 to a subscriber of the control panel 106(1), e.g., the CPMS client 122(1). Using the status simulation to provide status information 120 to the subscribers of a control panel 106 may significantly reduce the load place on control panels 106, which are normally devices having limited processing capability and often unable to scale as the number of subscribers and/or control sensors 108 increases.

In an alternative or additional aspect, wherein the control panel is a first control panel and the status simulation is a first status simulation, the method may further comprise receiving an unsolicited message from a second control panel, determining that a second status simulation has not been generated for the second control panel, and discarding the unsolicited message without using the unsolicited message for generating the second status simulation.

In an alternative or additional aspect, generating the status simulation for the control panel based on the plurality of event messages may comprise identifying a first message of the plurality of event messages as an unsolicited message, confirming, based on the identifying, that the first message meets a freshness policy, determining that the first message includes a status state of a control sensor of the plurality of control sensors, determining that the status state represents an active event at the control sensor, and setting, based on the status state representing the active event, the status state of the control sensor to active within the status simulation.

In an alternative or additional aspect, generating the status simulation for the control panel based on the plurality of event messages may comprise identifying a first message of the plurality of event messages as an unsolicited message, confirming, based on the identifying, that the first message meets a freshness policy, determining that the first message includes a status state of a control sensor of the plurality of control sensors, the status state clearing an active event at the control sensor, determining, based on an event identifier, the active event is represented within the status simulation, and removing, based on the status state identifying the active event, a representation of the active event from the status simulation.

In an alternative or additional aspect, wherein the control panel is a first control panel and the status simulation is a first status simulation, the method may further comprise receiving an unsolicited message from a second control panel, determining that a second status simulation has been generated for the second control panel, confirming, based on the second status simulation being generated, that the unsolicited message meets a freshness policy, determining that the unsolicited message includes a status state of a control sensor of the plurality of control sensors, the status state clearing an active event at the control sensor, determining, based on an event identifier, that the active event is not represented within the status simulation; and discarding the unsolicited message without using the unsolicited message for updating the second status simulation.

In an alternative or additional aspect, the method may further comprise receiving a message from the control panel, and discarding, based on the message not including a status state of a control sensor of the plurality of control sensors, the message without using the message for the generating.

In an alternative or additional aspect, transmitting the status information for the control panel may comprise receiving a request from the client service for the status information, generating, in response to the request, the status information from the status simulation without requesting event information from the control panel, and transmitting, in response to request, the status information to the client service.

In an alternative or additional aspect, the status information includes a plurality of status states, wherein individual status states of the plurality of status states identifying a status of an individual control sensor of the plurality of control sensors.

In an alternative or additional aspect, the control panel is a fire panel and a status state of the plurality of status states includes fire, trouble, or supervisory.

While the foregoing disclosure discusses illustrative aspects and/or embodiments, it should be noted that various changes and modifications could be made herein without departing from the scope of the described aspects and/or embodiments as defined by the appended claims. Furthermore, although elements of the described aspects and/or embodiments may be described or claimed in the singular, the plural is contemplated unless limitation to the singular is explicitly stated. Additionally, all or a portion of any aspect and/or embodiment may be utilized with all or a portion of any other aspect and/or embodiment, unless stated otherwise.

## Claims

1. A method for event monitoring at a cloud service, comprising:
- receiving, from a control panel (106) coupled with a plurality of control sensors (108(i)-(n)) within a supervised premises, a plurality of event messages corresponding to events detected by the plurality of control sensors (108(i)-(n)) within the supervised premises;
the method being **characterized by**
- generating a status simulation for the control panel (106) based on the plurality of event messages, the status simulation representing a current status of the control panel (106);
- creating a subscription of a client service to the control panel (106) based on a request from the client service; and
- transmitting, to the client service based on the subscription, status information for the control panel (106) derived from the status simulation.

2. The method of claim 1,
wherein the control panel (106) is a first control panel (106) and the status simulation is a first status simulation, and further comprising :
- receiving an unsolicited message from a second control panel (106);
- determining that a second status simulation has not been generated for the second control panel (106); and
- discarding the unsolicited message without using the unsolicited message for generating the second status simulation.

3. The method of claim 1 or 2,
wherein generating the status simulation for the control panel (106) based on the plurality of event messages comprises:
- identifying a first message of the plurality of event messages as an unsolicited message;
- confirming, based on the identifying, that the first message meets a freshness policy;
- determining that the first message includes a status state of a control sensor (108) of the plurality of control sensors (108(i)-(n));
- determining that the status state represents an active event at the control sensor (108); and
- setting, based on the status state representing the active event, the status state of the control sensor (108) to active within the status simulation.

4. The method of any one of claims 1 to 3,
wherein generating the status simulation for the control panel (106) based on the plurality of event messages comprises:
- identifying a first message of the plurality of event messages as an unsolicited message;
- confirming, based on the identifying, that the first message meets a freshness policy;
- determining that the first message includes a status state of a control sensor (108) of the plurality of control sensors (108(i)-(n)), the status state clearing an active event at the control sensor (108);
- determining, based on an event identifier, the active event is represented within the status simulation; and
- removing, based on the status state identifying the active event, a representation of the active event from the status simulation.

5. The method of any one of claims 1 to 4,
wherein the control panel (106) is a first control panel (106) and the status simulation is a first status simulation, and further comprising:
- receiving an unsolicited message from a second control panel (106);
- determining that a second status simulation has been generated for the second control panel (106);
- confirming, based on the second status simulation being generated, that the unsolicited message meets a freshness policy;
- determining that the unsolicited message includes a status state of a control sensor (108) of the plurality of control sensors (108(i)-(n)), the status state clearing an active event at the control sensor (108);
- determining, based on an event identifier, that the active event is not represented within the status simulation; and
- discarding the unsolicited message without using the unsolicited message for updating the second status simulation.

6. The method of any one of claims 1 to 5, further comprising :
- receiving a message from the control panel (106); and
- discarding, based on the message not including a status state of a control sensor (108) of the plurality of control sensors (108(i)-(n)), the message without using the message for the generating;
and/or
further comprising:
- configuring the control panel (106) to discard requests from the client service; or
- configuring the client service to only transmit status request associated with the control panel (106) to the cloud service.

7. The method of any one of claims 1 to 6,
wherein transmitting the status information for the control panel (106) comprises:
- receiving the request from the client service for the status information;
- generating, in response to the request, the status information from the status simulation without requesting event information from the control panel (106); and
- transmitting, in response to request, the status information to the client service.

8. The method of any one of claims 1 to 7,
wherein the status information includes a plurality of status states,
wherein individual status states of the plurality of status states identifying a status of an individual control sensor (108) of the plurality of control sensors (108(i)-(n));
preferably wherein the control panel (106) is a fire panel and a status state of the plurality of status states includes fire, trouble, or supervisory.

9. An apparatus for event monitoring at a cloud service, comprising:
- a memory (304); and
- a processor (302) communicatively coupled with the memory (304) and configured to:
- receive, from a control panel (106) coupled with a plurality of control sensors (108(i)-(n)) within a supervised premises, a plurality of event messages corresponding to events detected by the plurality of control sensors (108(i)-(n)) within the supervised premises;
- generate a status simulation for the control panel (106) based on the plurality of event messages, the status simulation representing a current status of the control panel (106);
- create a subscription of a client service to the control panel (106) based on a request from the client service; and
- transmit, to the client service based on the subscription, status information for the control panel (106) derived from the status simulation.

10. The apparatus of claim 9,
wherein the control (106) panel is a first control panel (106) and the status simulation is a first status simulation, and wherein the processor (302) is further configured to:
- receive an unsolicited message from a second control panel (106);
- determine that a second status simulation has not been generated for the second control panel (106); and
- discard the unsolicited message without using the unsolicited message for generating the second status simulation.

11. The apparatus of claim 9 or 10,
wherein to generate the status simulation for the control panel (106) based on the plurality of event messages comprises to:
- identify a first message of the plurality of event messages as an unsolicited message;
- confirm, based on the identifying, that the first message meets a freshness policy;
- determine that the first message includes a status state of a control sensor (108) of the plurality of control sensors (108(i)-(n));
- determine that the status state represents an active event at the control sensor (108); and
- set, based on the status state representing the active event, the status state of the control sensor (108) to active within the status simulation;
and/or
wherein to generate the status simulation for the control panel (106) based on the plurality of event messages comprises to:
- identify a first message of the plurality of event messages as an unsolicited message;
- confirm, based on the identifying, that the first message meets a freshness policy;
- determine that the first message includes a status state of a control sensor (108) of the plurality of control sensors (108(i)-(n)), the status state clearing an active event at the control sensor (108);
- determine, based on an event identifier, the active event is represented within the status simulation; and
- remove, based on the status state identifying the active event, a representation of the active event from the status simulation.

12. The apparatus of any one of claims 9 to 11,
wherein the control panel (106) is a first control panel (106) and the status simulation is a first status simulation, and wherein the processor (302) is further configured to:
- receive an unsolicited message from a second control panel (106);
- determine that a second status simulation has been generated for the second control panel (106);
- confirm, based on the second status simulation being generated, that the unsolicited message meets a freshness policy;
- determine that the unsolicited message includes a status state of a control sensor (108) of the plurality of control sensors (108(i)-(n)), the status state clearing an active event at the control sensor (108);
- determine, based on an event identifier, that the active event is not represented within the status simulation; and
- discard the unsolicited message without using the unsolicited message for updating the second status simulation.

13. The apparatus of any one of claims 9 to 12,
wherein the processor (302) is further configured to :
- receive a message from the control panel (106); and
- discard, based on the message not including a status state of a control sensor (108) of the plurality of control sensors (108(i)-(n)), the message without using the message for the generating;
and/or
wherein the processor (302) is further configured to:
- configure the control panel (106) to discard requests from the client service; or
- configure the client service to only transmit status request associated with the control panel (106) to the cloud service.

14. The apparatus of any one of claims 9 to 13,
wherein to transmit the status information for the control panel (106) comprises to:
- receive the request from the client service for the status information;
- generate, in response to the request, the status information from the status simulation without requesting event information from the control panel (106); and
- transmit, in response to request, the status information to the client service;
and/or
wherein the status information includes a plurality of status states,
wherein individual status states of the plurality of status states identifying a status of an individual control sensor (108) of the plurality of control sensors (108(i)-(n)).

15. A computer-readable medium storing instructions for event monitoring at a cloud service, wherein the instructions are executable by a processor (302) to:
- receive, from a control panel (106) coupled with a plurality of control sensors (108(i)-(n)) within a supervised premises, a plurality of event messages corresponding to events detected by the plurality of control sensors (108(i)-(n)) within the supervised premises;
- generate a status simulation for the control panel (106) based on the plurality of event messages, the status simulation representing a current status of the control panel (106);
- create a subscription of a client service to the control panel (106) based on a request from the client service; and
- transmit, to the client service based on the subscription, status information for the control panel (106) derived from the status simulation.

## Patentansprüche

1. Verfahren zur Ereignisüberwachung in einem Cloud-Dienst, umfassend:
- Empfangen, von einer Kontrolltafel (106), die mit einer Vielzahl von Kontrollsensoren (108(i)-(n)) innerhalb einer überwachten Liegenschaft gekoppelt ist, einer Vielzahl von Ereignismeldungen, die Ereignissen entsprechen, die durch die Vielzahl von Kontrollsensoren (108(i)-(n)) innerhalb der überwachten Liegenschaft erfasst werden;
wobei das Verfahren **gekennzeichnet ist durch**:
- das Erzeugen einer Zustandssimulation für die Kontrolltafel (106) basierend auf der Vielzahl von Ereignismeldungen, wobei die Zustandssimulation einen aktuellen Zustand der Kontrolltafel (106) darstellt;
- das Erstellen eines Abonnements eines Client-Dienstes für die Kontrolltafel (106) basierend auf einer Anfrage vom Client-Dienst; und
- Übertragen von Zustandsinformationen für die Kontrolltafel (106), die von der Zustandssimulation abgeleitet sind, an den Client-Dienst basierend auf dem Abonnement.

2. Verfahren nach Anspruch 1,
wobei die Kontrolltafel (106) eine erste Kontrolltafel (106) ist und die Zustandssimulation eine erste Zustandssimulation ist und außerdem Folgendes umfasst:
- Empfangen einer nicht angeforderten Meldung von einer zweiten Kontrolltafel (106);
- Bestimmen, dass keine zweite Zustandssimulation für die zweite Kontrolltafel (106) erzeugt wurde; und
- Verwerfen der nicht angeforderten Meldung, ohne die nicht angeforderte Meldung zu verwenden, um die zweite Zustandssimulation zu erzeugen.

3. Verfahren nach Anspruch 1 oder 2,
wobei das Erzeugen der Zustandssimulation für die Kontrolltafel (106) basierend auf der Vielzahl von Ereignismeldungen umfasst:
- Identifizieren einer ersten Meldung der Vielzahl von Ereignismeldungen als nicht angeforderte Meldung;
- Bestätigen, basierend auf dem Identifizieren, dass die erste Meldung einem Frischegrundsatz entspricht;
- Bestimmen, dass die erste Meldung einen Zustandsstatus eines Kontrollsensors (108) der Vielzahl von Kontrollsensoren (108(i)-(n)) umfasst;
- Bestimmen, dass der Zustandsstatus ein aktives Ereignis am Kontrollsensor (108) darstellt; und
- Einstellen, basierend auf dem Zustandsstatus, der das aktive Ereignis darstellt, des Zustandsstatus des Kontrollsensors (108) auf aktiv innerhalb der Zustandssimulation.

4. Verfahren nach einem der Ansprüche 1 bis 3,
wobei das Erzeugen der Zustandssimulation für die Kontrolltafel (106) basierend auf der Vielzahl von Ereignismeldungen Folgendes umfasst:
- Identifizieren einer ersten Meldung der Vielzahl von Meldungen als nicht angeforderte Meldung;
- Bestätigen, basierend auf dem Identifizieren, dass die erste Meldung einem Frischegrundsatz entspricht;
- Bestimmen, dass die erste Meldung einen Zustandsstatus eines Kontrollsensors (108) der Vielzahl von Kontrollsensoren (108(i)-(n)) umfasst, wobei der Zustandsstatus ein aktives Ereignis am Kontrollsensor (108) freigibt;
- Bestimmen, basierend auf einer Ereigniskennung, dass das aktive Ereignis in einer Zustandssimulation dargestellt wird; und
- Entfernen, basierend auf der Zustandsstatusidentifizierung des aktiven Ereignisses, einer Darstellung des aktiven Ereignisses aus der Zustandssimulation.

5. Verfahren nach einem der Ansprüche 1 bis 4,
wobei die Kontrolltafel (106) eine erste Kontrolltafel (106) ist und die Zustandssimulation eine erste Zustandssimulation ist und Folgendes umfasst:
- Empfangen einer nicht angeforderten Meldung von einer zweiten Kontrolltafel (106);
- Bestimmen, dass eine zweite Zustandssimulation für die zweite Kontrolltafel (106) erzeugt wurde;
- Bestätigen, basierend auf der zweiten Zustandssimulation, die erzeugt wird, dass die nicht angeforderte Meldung einem Frischegrundsatz entspricht;
- Bestimmen, dass die nicht angeforderte Meldung einen Zustandsstatus eines Kontrollsensors (108) der Vielzahl von Kontrollsensoren (108(i)-(n)) umfasst, wobei der Zustandsstatus ein aktives Ereignis am Kontrollsensor (108) freigibt;
- Bestimmen, basierend auf einer Ereigniskennung, dass das aktive Ereignis in der Zustandssimulation nicht dargestellt wird; und
- Verwerfen der nicht angeforderten Meldung, ohne die nicht angeforderte Meldung zu verwenden, um die zweite Zustandssimulation zu aktualisieren.

6. Verfahren nach einem der Ansprüche 1 bis 5, außerdem umfassend:
- Empfangen einer Meldung von der Kontrolltafel (106); und
- Verwerfen, basierend darauf, dass die Meldung keinen Zustandsstatus eines Kontrollsensor (108) der Vielzahl von Kontrollsensoren (108(i)-(n)) umfasst, der Meldung, ohne die Meldung für das Erzeugen zu verwenden;
und/oder
außerdem umfassend:
- Konfigurieren der Kontrolltafel (106), um Anfragen vom Client-Dienst zu verwerfen; oder
- Konfigurieren des Client-Dienstes, um nur Zustandsanfragen, die mit der Kontrolltafel (106) assoziiert sind, an den Cloud-Dienst zu übertragen.

7. Verfahren nach einem der Ansprüche 1 bis 6,
wobei das Übertragen der Zustandsinformationen für die Kontrolltafel (106) umfasst:
- Empfangen der Anfrage nach den Zustandsinformationen vom Client-Dienst;
- Erzeugen, als Reaktion auf die Anfrage, der Zustandsinformationen aus der Zustandssimulation, ohne Ereignisinformationen von der Kontrolltafel (106) anzufragen; und
- Übertragen, als Reaktion auf die Anfrage, der Zustandsinformationen an den Client-Dienst.

8. Verfahren nach einem der Ansprüche 1 bis 7,
wobei die Zustandsinformationen eine Vielzahl von Zustandsstatus umfassen,
wobei einzelne Zustandsstatus der Vielzahl von Zustandsstatus einen Zustand eines einzelnen Kontrollsensors (108) der Vielzahl von Kontrollsensoren (108(i)-(n)) identifizieren;
wobei die Kontrolltafel (106) vorzugsweise eine Feuertafel ist und ein Zustandsstatus der Vielzahl von Zustandsstatus Feuer, Probleme oder Überwachung umfasst.

9. Gerät zur Ereignisüberwachung in einem Cloud-Dienst, umfassend:
- einen Speicher (304); und
- einen Prozessor (302), der kommunikativ mit dem Speicher (304) gekoppelt und ausgelegt ist, um:
- von einer Kontrolltafel (106), die mit einer Vielzahl von Kontrollsensoren (108(i)-(n)) innerhalb einer überwachten Liegenschaft gekoppelt ist, eine Vielzahl von Ereignismeldungen zu empfangen, die Ereignissen entsprechen, die durch die Vielzahl von Kontrollsensoren (108(i)-(n)) innerhalb der überwachten Liegenschaft erfasst werden;
- eine Zustandssimulation für die Kontrolltafel (106) basierend auf der Vielzahl von Ereignismeldungen zu erzeugen, wobei die Zustandssimulation einen aktuellen Zustand der Kontrolltafel (106) darstellt;
- ein Abonnement eines Client-Dienstes für die Kontrolltafel (106) basierend auf einer Anfrage vom Client-Dienst zu erstellen; und
- Zustandsinformationen für die Kontrolltafel (106), die von der Zustandssimulation abgeleitet sind, basierend auf dem Abonnement an den Client-Dienst zu übertragen.

10. Gerät nach Anspruch 9,
wobei die Kontrolltafel (106) eine erste Kontrolltafel (106) ist und die Zustandssimulation eine erste Zustandssimulation ist und wobei der Prozessor (302) außerdem ausgelegt ist, um:
- eine nicht angeforderte Meldung von einer zweiten Kontrolltafel (106) zu empfangen;
- zu bestimmen, dass keine zweite Zustandssimulation für die zweite Kontrolltafel (106) erzeugt wurde; und
- die nicht angeforderte Meldung zu verwerfen, ohne die nicht angeforderte Meldung zu verwenden, um die zweite Zustandssimulation zu erzeugen.

11. Gerät nach Anspruch 9 oder 10,
wobei das Erzeugen der Zustandssimulation für die Kontrolltafel (106) basierend auf der Vielzahl von Ereignismeldungen umfasst:
- eine erste Meldung der Vielzahl von Ereignismeldungen als nicht angeforderte Meldung zu identifizieren;
- zu bestätigen, basierend auf dem Identifizieren, dass die erste Meldung einem Frischegrundsatz entspricht;
- zu bestimmen, dass die erste Meldung einen Zustandsstatus eines Kontrollsensors (108) der Vielzahl von Kontrollsensoren (108(i)-(n)) umfasst;
- zu bestimmen, dass der Zustandsstatus ein aktives Ereignis am Kontrollsensor (108) darstellt; und
- basierend auf dem Zustandsstatus, der das aktive Ereignis darstellt, den Zustandsstatus des Kontrollsensors (108) auf aktiv innerhalb der Zustandssimulation einzustellen;
und/oder
wobei das Erzeugen der Zustandssimulation für die Kontrolltafel (106) basierend auf der Vielzahl von Ereignismeldungen umfasst:
- eine erste Meldung der Vielzahl von Meldungen als nicht angeforderte Meldung zu identifizieren;
- zu bestätigen, basierend auf dem Identifizieren, dass die erste Meldung einem Frischegrundsatz entspricht;
- zu bestimmen, dass die erste Meldung einen Zustandsstatus eines Kontrollsensors (108) der Vielzahl von Kontrollsensoren (108(i)-(n)) umfasst, wobei der Zustandsstatus ein aktives Ereignis am Kontrollsensor (108) freigibt;
- zu bestimmen, basierend auf einer Ereigniskennung, dass das aktive Ereignis in einer Zustandssimulation dargestellt wird; und
- basierend auf dem Zustandsstatus, der das aktive Ereignis identifiziert, eine Darstellung des aktiven Ereignisses aus der Zustandssimulation zu entfernen.

12. Gerät nach einem der Ansprüche 9 bis 11,
wobei die Kontrolltafel (106) eine erste Kontrolltafel (106) ist und die Zustandssimulation eine erste Zustandssimulation ist und wobei der Prozessor (302) außerdem ausgelegt ist, um:
- eine nicht angeforderte Meldung von einer zweiten Kontrolltafel (106) zu empfangen;
- zu bestimmen, dass eine zweite Zustandssimulation für die zweite Kontrolltafel (106) erzeugt wurde;
- zu bestätigen, basierend auf der zweiten Zustandssimulation, die erzeugt wird, dass die nicht angeforderte Meldung einem Frischegrundsatz entspricht;
- zu bestimmen, dass die nicht angeforderte Meldung einen Zustandsstatus eines Kontrollsensors (108) der Vielzahl von Kontrollsensoren (108(i)-(n)) umfasst, wobei der Zustandsstatus ein aktives Ereignis am Kontrollsensor (108) freigibt;
- zu bestimmen, basierend auf einer Ereigniskennung, dass das aktive Ereignis in der Zustandssimulation nicht dargestellt wird; und
- die nicht angeforderte Meldung zu verwerfen, ohne die nicht angeforderte Meldung zu verwenden, um die zweite Zustandssimulation zu aktualisieren.

13. Gerät nach einem der Ansprüche 9 bis 12, wobei der Prozessor außerdem ausgelegt ist, um:
- eine Meldung von der Kontrolltafel (106) zu empfangen; und
- basierend darauf, dass die Meldung keinen Zustandsstatus eines Kontrollsensor (108) der Vielzahl von Kontrollsensoren (108(i)-(n)) umfasst, die Meldung zu verwerfen, ohne die Meldung für das Erzeugen zu verwenden;
und/oder
wobei der Prozessor (302) außerdem ausgelegt ist, um:
- die Kontrolltafel (106) zu konfigurieren, um Anfragen vom Client-Dienst zu verwerfen; oder
- den Client-Dienst zu konfigurieren, um nur Zustandsanfragen, die mit der Kontrolltafel (106) assoziiert sind, an den Cloud-Dienst zu übertragen.

14. Gerät nach einem der Ansprüche 9 bis 13,
wobei das Übertragen der Zustandsinformationen für die Kontrolltafel (106) umfassen:
- die Anfrage nach den Zustandsinformationen vom Client-Dienst zu empfangen;
- als Reaktion auf die Anfrage, die Zustandsinformationen aus der Zustandssimulation zu erzeugen, ohne Ereignisinformationen von der Kontrolltafel (106) anzufragen; und
- als Reaktion auf die Anfrage, die Zustandsinformationen an den Client-Dienst zu übertragen;
und/oder
wobei die Zustandsinformationen eine Vielzahl von Zustandsstatus umfassen,
wobei einzelne Zustandsstatus der Vielzahl von Zustandsstatus einen Zustand eines einzelnen Kontrollsensors (108) der Vielzahl von Kontrollsensoren (108(i)-(n)) identifizieren.

15. Computerlesbares Medium, auf dem Anweisungen zur Ereignisüberwachung in einem Cloud-Dienst gespeichert sind, wobei die Anweisungen durch einen Prozessor (302) ausführbar sind, um:
- von einer Kontrolltafel (106), die mit einer Vielzahl von Kontrollsensoren (108(i)-(n)) innerhalb einer überwachten Liegenschaft gekoppelt ist, eine Vielzahl von Ereignismeldungen zu empfangen, die Ereignissen entsprechen, die durch die Vielzahl von Kontrollsensoren (108(i)-(n)) innerhalb der überwachten Liegenschaft erfasst werden;
- eine Zustandssimulation für die Kontrolltafel (106) basierend auf der Vielzahl von Ereignismeldungen zu erzeugen, wobei die Zustandssimulation einen aktuellen Zustand der Kontrolltafel (106) darstellt;
- ein Abonnement eines Client-Dienstes für die Kontrolltafel (106) basierend auf einer Anfrage vom Client-Dienst zu erstellen; und
- Zustandsinformationen für die Kontrolltafel (106), die von der Zustandssimulation abgeleitet sind, basierend auf dem Abonnement an den Client-Dienst zu übertragen.

## Revendications

1. Procédé permettant la surveillance d'événements au niveau d'un service cloud, comprenant :
- la réception, à partir d'un panneau de contrôle (106) couplé à une pluralité de capteurs de contrôle (108(i)-(n)) à l'intérieur d'un local supervisé, d'une pluralité de messages d'événements correspondant à des événements détectés par la pluralité de capteurs de contrôle (108(i)-(n)) à l'intérieur du local supervisé ;
le procédé étant **caractérisé par**
- la génération d'une simulation d'état pour le panneau de contrôle (106) sur la base de la pluralité de messages d'événements, la simulation d'état représentant un état actuel du panneau de contrôle (106) ;
- la création d'un abonnement d'un service client au panneau de contrôle (106) sur la base d'une demande du service client ; et
- la transmission, au service client sur la base de l'abonnement, d'informations d'état pour le panneau de contrôle (106) dérivées de la simulation d'état.

2. Procédé selon la revendication 1,
dans lequel le panneau de contrôle (106) est un premier panneau de contrôle (106) et la simulation d'état est une première simulation d'état, et comprenant en outre :
- la réception d'un message non sollicité provenant d'un second panneau de contrôle (106) ;
- la détermination qu'une seconde simulation d'état n'a pas été générée pour le second panneau de contrôle (106) ; et
- le rejet du message non sollicité sans utiliser le message non sollicité pour la génération de la seconde simulation d'état.

3. Procédé selon la revendication 1 ou 2,
dans lequel la génération de la simulation d'état pour le panneau de contrôle (106) sur la base de la pluralité de messages d'événements comprend :
- l'identification d'un premier message de la pluralité de messages d'événements en tant que message non sollicité ;
- la confirmation, sur la base de l'identification, que le premier message est conforme à une politique de fraîcheur ;
- la détermination que le premier message comporte un état de statut d'un capteur de contrôle (108) de la pluralité de capteurs de contrôle (108(i)-(n)) ; la détermination que l'état de statut représente un événement actif au niveau du capteur de contrôle (108) ; et
- la définition, sur la base de l'état de statut représentant l'événement actif, de l'état de statut du capteur de contrôle (108) sur actif dans la simulation d'état.

4. Procédé selon l'une quelconque des revendications 1 à 3,
dans lequel la génération de la simulation d'état pour le panneau de contrôle (106) sur la base de la pluralité de messages d'événements comprend :
- l'identification d'un premier message de la pluralité de messages d'événements en tant que message non sollicité ;
- la confirmation, sur la base de l'identification, que le premier message est conforme à une politique de fraîcheur ;
- la détermination que le premier message comporte un état de statut d'un capteur de contrôle (108) de la pluralité de capteurs de contrôle (108(i)-(n)), l'état de statut effaçant un événement actif au niveau du capteur de contrôle (108) ;
- la détermination, sur la base d'un identificateur d'événement, que l'événement actif est représenté dans la simulation d'état ; et
- la suppression, sur la base de l'état de statut identifiant l'événement actif, d'une représentation de l'événement actif à partir de la simulation d'état.

5. Procédé selon l'une quelconque des revendications 1 à 4,
dans lequel le panneau de contrôle (106) est un premier panneau de contrôle (106) et la simulation d'état est une première simulation d'état, et comprenant en outre :
- la réception d'un message non sollicité provenant d'un second panneau de contrôle (106) ;
- la détermination qu'une seconde simulation d'état a été générée pour le second panneau de contrôle (106) ;
- la confirmation, sur la base de la seconde simulation d'état étant générée, que le message non sollicité est conforme à une politique de fraîcheur ;
- la détermination que le message non sollicité comporte un état d'un capteur de contrôle (108) de la pluralité de capteurs de contrôle (108(i)-(n)), l'état effaçant un événement actif au niveau du capteur de contrôle (108) ;
- la détermination, sur la base d'un identificateur d'événement, que l'événement actif n'est pas représenté dans la simulation d'état ; et
- le rejet du message non sollicité sans utiliser le message non sollicité pour la mise à jour de la seconde simulation d'état.

6. Procédé selon l'une quelconque des revendications 1 à 5, comprenant en outre :
- la réception d'un message du panneau de contrôle (106) ; et
- le rejet, sur la base du message ne comportant pas un état d'un capteur de contrôle (108) de la pluralité de capteurs de contrôle (108(i)-(n)), du message sans utiliser le message pour la génération ;
et/ou
comprenant en outre :
- la configuration du panneau de contrôle (106) pour rejeter les demandes du service client ; ou
- la configuration du service client pour transmettre uniquement la demande d'état associée au panneau de contrôle (106) au service cloud.

7. Procédé selon l'une quelconque des revendications 1 à 6,
dans lequel la transmission des informations d'état pour le panneau de contrôle (106) comprend :
- la réception de la demande du service client pour les informations d'état ;
- la génération, en réponse à la demande, des informations d'état à partir de la simulation d'état sans demander d'informations d'événement au panneau de contrôle (106) ; et
- la transmission, en réponse à la demande, des informations d'état au service client.

8. Procédé selon l'une quelconque des revendications 1 à 7,
dans lequel les informations d'état comportent une pluralité d'états de statut, dans lequel les états de statut individuels de la pluralité d'états de statut identifient un état d'un capteur de contrôle individuel (108) de la pluralité de capteurs de contrôle (108(i)-(n)) ;
de préférence dans lequel le panneau de contrôle (106) est un panneau d'incendie et un état de statut de la pluralité d'états comporte un incendie, une panne ou une supervision.

9. Appareil permettant la surveillance d'événements au niveau d'un service cloud, comprenant :
- une mémoire (304) ; et
- un processeur (302) couplé de manière communicative à la mémoire (304) et configuré pour :
- recevoir, d'un panneau de contrôle (106) couplé à une pluralité de capteurs de contrôle (108(i)-(n)) à l'intérieur d'un local supervisé, une
- pluralité de messages d'événements correspondant à des événements détectés par la pluralité de capteurs de contrôle (108(i)-(n)) à l'intérieur du local supervisé ;
- générer une simulation d'état pour le panneau de contrôle (106) sur la base de la pluralité de messages d'événements, la simulation d'état représentant un état actuel du panneau de contrôle (106) ;
- créer un abonnement d'un service client au panneau de contrôle (106) sur la base d'une demande du service client ; et
- transmettre, au service client sur la base de l'abonnement, des informations d'état pour le panneau de contrôle (106) dérivées de la simulation d'état.

10. Appareil selon la revendication 9,
dans lequel le panneau (106) de contrôle est un premier panneau de contrôle (106) et la simulation d'état est une première simulation d'état, et dans lequel le processeur (302) est en outre configuré pour :
- recevoir un message non sollicité d'un second panneau de contrôle (106) ;
- déterminer qu'une seconde simulation d'état n'a pas été générée pour le second panneau de contrôle (106) ; et
- rejeter le message non sollicité sans utiliser le message non sollicité pour la génération de la seconde simulation d'état.

11. Appareil selon la revendication 9 ou 10,
dans lequel générer la simulation d'état pour le panneau de contrôle (106) sur la base de la pluralité de messages d'événements comprend les étapes consistant à :
- identifier un premier message de la pluralité de messages d'événements en tant que message non sollicité ;
- confirmer, sur la base de l'identification, que le premier message est conforme à une politique de fraîcheur ;
- déterminer que le premier message comporte un état de statut d'un capteur de contrôle (108) de la pluralité de capteurs de contrôle (108(i)-(n)) ;
- déterminer que l'état de statut représente un événement actif au niveau du capteur de contrôle (108) ; et
- définir, sur la base de l'état représentant l'événement actif, l'état du capteur de contrôle (108) sur actif dans la simulation d'état ;
et/ou
dans lequel générer la simulation d'état pour le panneau de contrôle (106) sur la base de la pluralité de messages d'événements comprend les étapes consistant à :
- identifier un premier message de la pluralité de messages d'événements en tant que message non sollicité ;
- confirmer, sur la base de l'identification, que le premier message est conforme à une politique de fraîcheur ;
- déterminer que le premier message comporte un état de statut d'un capteur de contrôle (108) de la pluralité de capteurs de contrôle (108(i)-(n)), l'état de statut effaçant un événement actif au niveau du capteur de contrôle (108) ;
- déterminer, sur la base d'un identificateur d'événement, que l'événement actif est représenté dans la simulation d'état ; et
- supprimer, sur la base de l'état identifiant l'événement actif, une représentation de l'événement actif de la simulation d'état.

12. Appareil selon l'une quelconque des revendications 9 à 11,
dans lequel le panneau de contrôle (106) est un premier panneau de contrôle (106) et la simulation d'état est une première simulation d'état, et dans lequel le processeur (302) est en outre configuré pour :
- recevoir un message non sollicité d'un second panneau de contrôle (106) ;
- déterminer qu'une seconde simulation d'état a été générée pour le second panneau de contrôle (106) ;
- confirmer, sur la base de la seconde simulation d'état générée, que le message non sollicité est conforme à une politique de fraîcheur ;
- déterminer que le message non sollicité comporte un état de statut d'un capteur de contrôle (108) de la pluralité de capteurs de contrôle (108(i)-(n)), l'état de statut effaçant un événement actif au niveau du capteur de contrôle (108) ;
- déterminer, sur la base d'un identificateur d'événement, que l'événement actif n'est pas représenté dans la simulation d'état ; et
- rejeter le message non sollicité sans utiliser le message non sollicité pour la mise à jour de la seconde simulation d'état.

13. Appareil selon l'une quelconque des revendications 9 à 12,
dans lequel le processeur (302) est en outre configuré pour :
- recevoir un message du panneau de contrôle (106) ; et
- rejeter, sur la base du message ne comportant pas un état d'un capteur de contrôle (108) de la pluralité de capteurs de contrôle (108(i)-(n)), le message sans utiliser le message pour la génération ;
et/ou
dans lequel le processeur (302) est en outre configuré pour :
- configurer le panneau de contrôle (106) pour rejeter les demandes du service client ; ou
- configurer le service client pour transmettre uniquement la demande d'état associée au panneau de contrôle (106) au service cloud.

14. Appareil selon l'une quelconque des revendications 9 à 13,
dans lequel transmettre les informations d'état pour le panneau de contrôle (106) comprend les étapes consistant à :
- recevoir la demande du service client pour les informations d'état ;
- générer, en réponse à la demande, les informations d'état à partir de la simulation d'état sans demander d'informations d'événement au panneau de contrôle (106) ; et
- transmettre, en réponse à la demande, les informations d'état au service client ;
et/ou
dans lequel les informations d'état comportent une pluralité d'états, dans lequel les états individuels de la pluralité d'états identifient un état d'un capteur de contrôle individuel (108) de la pluralité de capteurs de contrôle (108(i)-(n)).

15. Support lisible par ordinateur stockant des instructions pour la surveillance d'événements au niveau d'un service cloud, dans lequel les instructions sont exécutables par un processeur (302) pour :
- recevoir, d'un panneau de contrôle (106) couplé à plusieurs capteurs de contrôle (108(i)-(n)) à l'intérieur d'un local supervisé, une pluralité de messages d'événements correspondant à des événements détectés par la pluralité de capteurs de contrôle (108(i)-(n)) à l'intérieur du local supervisé ;
- générer une simulation d'état pour le panneau de contrôle (106) sur la base de la pluralité de messages d'événements, la simulation d'état représentant un état actuel du panneau de contrôle (106) ;
- créer un abonnement d'un service client au panneau de contrôle (106) sur la base d'une demande du service client ; et
- transmettre, au service client sur la base de l'abonnement, des informations d'état pour le panneau de contrôle (106) dérivées de la simulation d'état.
